# EUROPEAN PATENT SPECIFICATION

(11) **EP 2 946 398 B1**
(45) Date of publication and mention of the grant of the patent: **07.03.2018**
(21) Application number: 14701440.1
(22) Date of filing: 20.01.2014
(51) Int. Cl.: H01J 37/22, H01J 37/30, H01J 37/304, G02B 21/36

(54) **OPTICAL AND INTEGRATED INSPECTION APPARATUS AND METHOD**
INTEGRIERTE OPTISCHE INSPEKTIONSVORRICHTUNG UND VERFAHREN DAFÜR
APPAREIL D'INSPECTION OPTIQUE ET INTÉGRÉ ET PROCÉDÉ ASSOCIÉ

(30) Priority: 18.01.2013 NL 1040008
(43) Date of publication of application: 25.11.2015
(73) Proprietor: Delmic B.V., 2629 JD Delft (NL)
(72) Inventor: HOOGENBOOM, Jacob Pieter, NL-2628 CN Delft (NL); HARING, Martijn Theo, NL-2628 CN Delft (NL)
(74) Representative: Peters, Sebastian Martinus
(86) International application number: PCT/NL2014/050024
(87) International publication number: WO 2014/112877

(56) References cited:
- EP-A1- 1 953 791
- EP-A2- 1 785 714
- WO-A1-2009/059378
- JP-A- H09 283 073

## Description

### BACKGROUND

### Field of the Invention

The present invention relates to an improvement in a so-called integrated inspection apparatus, featuring the integration of a scanning charged particle microscope, in particular a scanning electron microscope (SEM), and light microscope optics. The improvement in particular relates to extension in functionality of such integrated systems, amongst others towards a new and simplified method of operating such systems, as well as to characterizing of optical components.

More in particular the method and apparatus relate to so called image registration and characterization of chromatic aberrations in a multi-color optical microscope equipped and/or integrated with a charged particle beam apparatus.

In this respect, it is noted that information obtained from images with light microscopy and electron microscopy is to a large extent complementary. With a light microscope different objects can be seen and inspected in a specimen in different colors, which allows for identification of part or whole of the composition of this specimen. Instead of directly observing color from a constituent of the specimen, very often specific color markers are attached, such as fluorophores or autofluorescent proteins, to a specific non-colored constituent for identification.

With an electron microscope, all constituents of a specimen can be imaged at very small detail (high resolution), much smaller than with a light microscope, but the ability to identify constituents based on color is absent.

In correlative light-electron microscopy, therefore, users try to obtain images from the same area of a specimen, the so called Region of Interest or ROI for short, with both the light and the electron microscope. A very accurate and quick way of doing this, is by using an integrated microscope wherein both types of microscope or parts thereof are to a more or less integrated extend contained in a single apparatus.

### Description of the Related Art

Such an integrated system is known in the art, e.g. from the short technical note "Specimen stage incorporating light microscopical optics for a Cambridge S 180 scanning electron microscope" by Wouters et al in J. of Microscopy Vol. 145, Feb. 1987, pp237-240. Recent improvements of that principle are provided by the Applicant in patent publication WO2012008836 and is in line with the present invention generally described as an inspection apparatus provided with an optical microscope and an ion- or electron microscope, equipped with a source for emitting a primary beam of charged particles to a sample in a sample holder. The apparatus comprises a detector for detection of secondary radiation and/or charged particles backscattered from the sample and induced by the primary beam. The optical microscope is equipped with a light collecting and recording device such as a CCD camera or other light recording device, to receive in use luminescence light emitted by the sample.

In correlative microscopy, users aim to image the same area of a sample with both the light and the electron microscope. The problem in this practice is that both images have different magnification, possibly both in x and y, and rotation orientation. Also, the images have different contrast, which means that some features that are visible in one image cannot be seen in the other, and vice versa. Known methods to overcome this problem are to put the samples on a microscope slide, or support grid, that has markers which can be recognized in both images. Another method is to inject markers into the sample. See for example, "The use of markers for Correlative Microscopy" Brown & Verkade, Protoplasma, 244, pp. 91-94, 2010.

One of the essential points of correlative microscopy, i.e. the process of inspecting the same sample with two different investigative methods, is overlaying datasets of the two methods as precisely and accurate as possible. In the case of correlative light-electron microscopy, this means an x-, y-, and occasional z-, overlay between an optical image and an electron image. The process of achieving this overlay is non-trivial and may be cumbersome.

Another issue of correlative light-electron microscopy, alternatively denoted integrated light-electron microscopy, relates to the characterization of chromatic aberration. In a multi-color optical microscope, images are recorded of the same area of a sample in different, spectrally separated detection channels. The information from these different images is then combined, e.g. to determine the extent of overlap in expression between the separate images. Due to chromatic distortions and aberrations a single location on a sample may appear shifted in different color images, i.e. the images are not correctly registered. To accurately combine information from the different spectral bands, one needs to correct for such chromatic distortions and aberrations. Also, it may be desired to overlay the separate spectral images onto an image from another technique, such as electron or ion microscopy, charged particle microscopy in general. In that case, the registration between the color images needs to be performed with an accuracy similar to the resolution of the electron or ion microscope.

Microscope objective lenses can be obtained that are corrected for chromatic aberrations, but the correction typically only holds for three to five narrow spectral bands, while the information one wants to obtain may be visible in a non-corrected band. In addition, the insertion of additional optical components such as a filter may add distortions or aberrations, and, importantly, the accuracy with which aberration correction is carried out in the objective lens may still be insufficient to achieve accurate registration - the aberration correction is typically on the order of 50-100 nm, while registration accuracy of 5-20 nm is desired.

One manner of circumventing the above shortcoming in known integrated microscopy is explained in the publication "An efficient algorithm for measurement and correction of chromatic aberrations in fluorescence microscopy" as in Journal of Microscopy, Vol. 200, Pt 3, December 2000, pp. 206-217, by M. Kozubec and P. Matula. Where the method may be optimized and efficient in terms of the technology applied, it is in view of the desired improvement, e.g. towards the present invention, considered cumbersome by the requirement to insert markers in the sample. Apart from overcoming a requirement to prepare the sample, it is a further desire underlying the present invention, to increase a perceived limited accuracy of the known method. It is a further desire to increase the number of possible observations, now typically a number of markers in the range from two to four. It is yet a further desire underlying the present invention not to be limited to the location of the one or few markers that can be used in the known method.

Up to now the problems associated with the known methods and apparatuses have been resolved by carrying out aberration correction using optical components that correct for chromatic effects. In this way, correction can be performed in a finite number of narrow spectral bands, say 3 to 5 bands. Also, correction is limited typically to a value in the order and range of 50-100 nm. Chromatic aberrations can be determined using multi-color fluorescent spheres. These spheres emit fluorescent light in several spectral bands and can thus be detected in different spectral detection channels. By fitting the intensity profile in each spectral channel and finding the center, one can register the positions of the spheres and thus acquire a measure for the chromatic distortions and aberrations. Similarly, one can chemically link different fluorescent molecules, which makes them visible in different spectral channels, after which the same procedure as above can be carried out.

The drawbacks of these known techniques are that the registration can only be carried out for the positions where the spheres or molecules are located, which is a random number and a random distribution. The accuracy with which the registration can be carried out is still limited to about 20 nm at best. Also, one has to incorporate the spheres or molecules into a sample, or make a separate calibration sample containing the spheres or molecules. Using molecules, additional registration to another microscope modality such as electron or ion microscopy is not possible without additional means. The spheres would in principle be visible in such a microscope, so that multimodal registration could be carried out, albeit with the above mentioned drawbacks.

### SUMMARY OF THE INVENTION

According to a first aspect, the present invention provides an apparatus as described in enclosed claim 1. Preferred embodiments as described in the dependent claims.

According to a second aspect, the present invention provides a method as described in enclosed claim 8. Preferred embodiments as described in the dependent claims.

In the present invention a fundamental improvement is made in the practice of correlative microscopy, by an at hindsight relatively simple measure that obviates the specific manners for doing so as known to date. The measure according to the invention reduces complexity of correlative inspection, improves productivity and/or improves the quality and accuracy of inspection in that image. Both manners of inspection of an integrated apparatus can be compared simultaneously without undue complicating measures to either the apparatus or the sample.

The present invention provides an apparatus for inspecting a sample, said apparatus comprising:
an optical microscope system to observe a region of interest on a sample,
a charged particle system which is arranged for generating a focused beam of charged particles and projecting said focused beam on a position on said sample within said region of interest, and
a control unit for controlling said apparatus, wherein said control unit is arranged for recording two or more optical images of said region of interest with said optical microscope system, at least when said focused beam of charged particles impinges on said sample, wherein the apparatus is arranged for registering and/or correlating said two or more optical images by detecting a change in the two or more optical images as caused by said focused beam of charged particles.

According to the present invention, the measure towards obtaining these advantages requires detecting a change in the optical image caused by the focused charged particle beam and using the changes as recorded in said two or more optical images for correlation of the two or more images. Such detection and correlation is preferably performed in automated manner.

A requirement for observation of the charged particle beam signal, such as an electron beam signal, in the optical image is not trivial as the camera of the optical system part is often, in some cases even automatically, switched off during operation of the electron microscope. Hence the improvement by the invention also involves that in operation of the apparatus, both microscope systems are simultaneously switched on, in particular including the camera of the optical microscope system.

The present invention recognizes that when the camera is open or switched on, a point created by the charged particle system becomes a cathodoluminescent spot to be observed by the optical camera system, and that a coordinate system associated with the optical microscopy system may be matched to that of the charged particle system.

Preferably, the focused beam of charged particles is arranged to create a cathodoluminescent spot of a size below the optical resolution of the optical microscope system. Such a spot acts as a substantially perfect point source. By analyzing an optical image of such a point source, the geometrical optical aberrations and distortions of the optical microscope system can be determined.

In an embodiment, the control unit is arranged for determining aberrations and/or distortions of the optical microscope system by analyzing and/or comparing said two or more optical images.

Recognizing that in a purely optical system, the light collected by the optical microscopy system is typically in a range from 400 to 1000 nanometer, it was realized that the optical microscope system may also suffer from chromatic aberrations and distortions, in particular the optical components of said optical microscope system, such as the objective lens. Correction thereof is possible up to limited level, at specific wavelengths, and with limited accuracy.

It was further observed and realized that if a multi-channel microscope is used, multiple channels may be used for detecting different colors or wavelength ranges for different functions within a sample such as a biologic cell. With such a setup, according to the method of invention, a single spot may be observed, alternatively denoted imaged, by two or more channels or two different colors or wavelength ranges. In this embodiment, each of said two or more channels provides one of said two or more optical images according to the invention. By analyzing the optical images at said two different wavelength ranges of the point source, the chromatic aberrations and distortions of the optical microscope system can be determined.

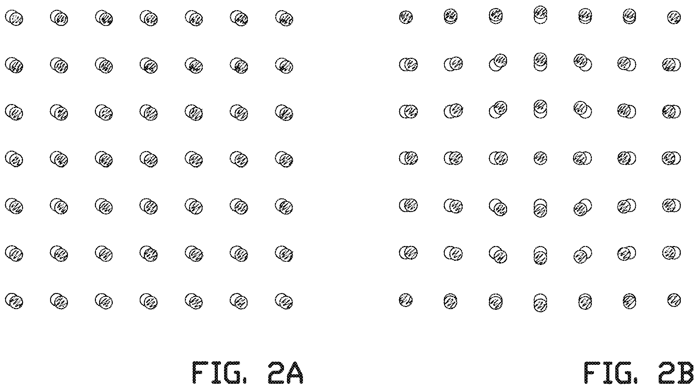

Where such image, without application of the measures of invention, may either be displaced or have a chromatic effect, e.g. as depicted in Figures 2A and 2B respectively, the use or application of dual or multiple channel or color imaging in combination with colored markers allows for correction. Under the present invention, i.e. under combined use of the optical and charged particle microscope systems and using dual or multiple color channel imaging, no markers are required and the number of structures in a sample to be imaged may be unlimited.

Hence, in an integrated light-electron microscope, the position of the electron beam is visible in the optical image through the cathodoluminescence generated in a sample substrate or in the sample itself and this effect can be used to very accurately align the optical image onto the electron microscope image. It is recognized that for specific substrates or samples, the cathodoluminescence signal can have a very broad wavelength range and in fact can span the entire visible wavelength range and beyond. By recording this signal in different spectral detection channels, a highly accurate, typically down to 5 nm registration between the color images can be made (versus 50 to 100 nm in optimized contemporary systems), and the registration can be performed over the entire image area.

It is further recognized that the method of invention can also be used to characterize the degree of distortions and aberrations which can be, but are not limited to, chromatic effects, in an objective lens or other optical component or combination of components or entire optical microscope system by performing a calibration experiment in an integrated light-electron microscope.

It is further recognized that where the present invention requires a sample or substrate to be responsive to charged particle impingement by a broad band optical output, most substrate materials, including glass which is applied in large volume, have a broad optical spectrum output, which means that the present invention may have a very wide, virtually unhampered practical application. The present invention may be applied with a substrate either with or without a sample.

Another advantage of the present invention resides in that, unlike the case at using known markers in a sample, images may be automatically overlaid, whether spectrally different or not. Also, multiple cameras may be applied for capturing large samples. It is favorable that no charged particle beam image needs to be taken from the sample. Rather, the focused beam of charged particles is merely applied to temporary create a marker. In doing so, advantageously a feature of incrementally stepping the charged particle beam in small steps may be applied. In overlaying images these may be maintained at a same spectral characterization by, in accordance with further elaboration of the present invention, utilizing phase information in the images. In this manner exchange of spectral filter elements, as may be physically necessary in certain systems, may be obviated.

With the present invention, it is recognized that the electron microscope provides a unique, very accurately defined general coordinate frame and that this feature can be favorably used for detecting and/or correcting chromatic distortions and aberrations by mapping this coordinate frame into arbitrary color channels through broadband cathodoluminescence. This solution is accurate and has the ability to perform registration over a full image area. In particular with respect to the known solution, the present solution is more accurate, not limited in the number and spectral position of the detection channels, and it per-forms a full two dimensional registration. The invention is furthermore of significance in that at least to a large extend, the influence of an additional optical component in an integrated system can be mapped out.

It is noted that the various aspects and features described and shown in the specification can be applied, individually, wherever possible. These individual aspects, in particular the aspects and features described in the attached dependent claims, can be made subject of divisional patent applications.

### BRIEF DESCRIPTION OF THE DRAWINGS

Various aspects of the invention and certain examples of embodiments of the invention are illustrated in the drawings in which:
FIGURES 1A and 1B schematically depict a basic design of an apparatus as typically improved by the present invention and a practical elaboration thereof respectively;
FIGURE 2A and 2B each schematically provide an example of differences in two different image registrations, in the form of a translation and of a different displacement for each point of the image due to aberration and/or distortion of an optical component;
FIGURE 3A to 3D schematically illustrate various apparatus configurations for setting the method according to the present invention into practice; and
FIGURE 4 schematically illustrates a possibility of overlaying images as enabled by the invention.

### DETAILED DESCRIPTION OF THE INVENTION

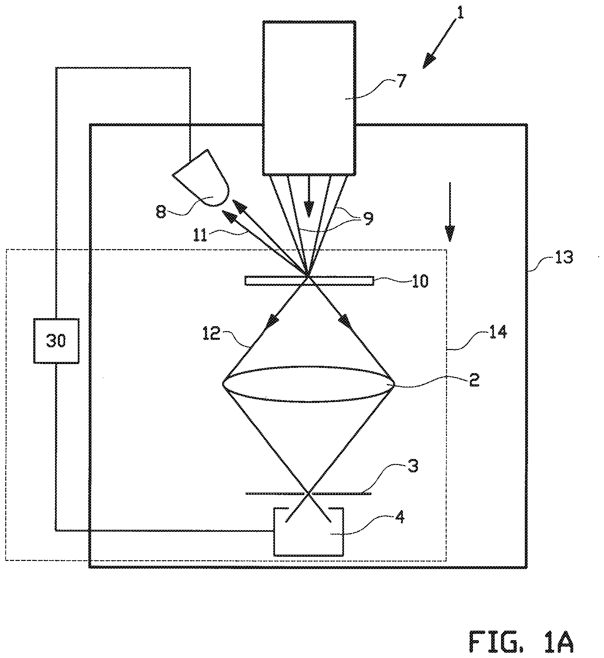

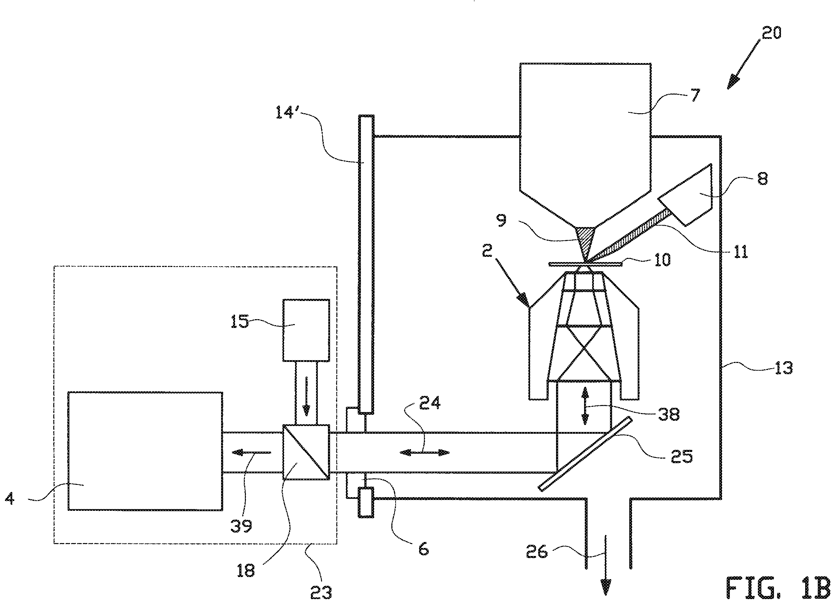

By way of exemplifying a typical context of the present invention, a principle and relatively simple set up of a so-called optical SEM combination as known from the prior art will be provided. This example however by no means excludes any known or yet unknown variation or alternative thereof. Hence, with reference first to figures 1A and 1B, the basic design of such an inspection apparatus 1 of the invention is explained.

Figure 1A shows an inspection apparatus 1 comprising, in combination, at least an optical microscope 2, 3, 4 to observe a region of interest on a sample 10 in a sample holder, and a charged particle microscope, such as an ion or electron microscope 7, 8 equipped with a source 7 for emitting a primary beam 9 of charged particles and to focus said charged particle beam 9 on a position on said sample 10 within said region of interest.

The charged particle microscope comprises a detector 8 for detection of secondary radiation or secondary charged particles 11 backscattered from the sample 10, or emitted, transmitted, or scattered from the sample 10 and possibly induced by the primary beam 9.

The optical microscope 2, 3, 4 is equipped with an light collecting device 2 to receive in use luminescence light 12 emitted by the sample and/or substrate 10 and induced by the primary beam 9 and to focus the luminescence light on a photon-detector 4. The light collecting device 2 may be an objective, a mirror or a glass fiber. It may also consist of a plurality of devices to arrange for collecting and focusing of the concerning luminescence light 12 that is emitted by the sample 10, e.g. using a known per se CCD camera.

In the present example the optical microscope 2, 3, 4 is of the confocal type having a pinhole 3 between the objective 2 and the photon-detector 4. In this embodiment the optical microscope 2, 3, 4 is placed entirely inside the vacuum chamber 13 of the ion- or electron microscope 7, 8. The closed dashed line 14 encircles those parts of the inspection apparatus 1 of the invention that may all or some of them be mounted on the (replaceable) door of the vacuum chamber 13, notably the sample holder for the sample 10, the light collecting device 2, the pinhole 3, and the photon-detector 4. This particular construction enables an easy retrofit or completion of an existing charged particle microscope according to prior art in order to convert it into an inspection apparatus of the integrated type as is subject to the present invention.

In figure 1A, a control unit 30, alternatively denoted controller or processor is provided and useable as an automation unit, e.g. in the form of a computer, including personal computer provided with dedicated software, implementing one or more methods of use of the inspection apparatus and controlling the integrated apparatus to a desired extend. The control unit 30 may typically be provided with one or more screens, e.g. one screen or screen part for depicting the recorded optical image, and the other or another part of the same screen depicting an image, in particular of the same object, i.e. substrate, recorded via the charged particle part of the inspection apparatus. In particular, said control unit 30 is arranged for recording two or more optical images of said region of interest with said optical microscope system 2, 3, 4, at least when said focused beam 9 of charged particles impinges on said sample 10.

Figure 1B by way of example illustrates another embodiment of an integrated system 20, in particular without such confocal detection system, in which the present invention may be applied. Figure 1B shows an illumination and detection box 23 comprising a light optical system part outside the vacuum housing 13. The light optical system comprises an illuminator or light source 15 emitting light which is reflected by a half mirror 18 and directed, via an optical window 6, a mirror 25 and a microscope objective 2 onto the sample 10 in order to illuminate said sample 10. Light coming from the sample 10 follows the same way 38, 34, back to the illumination and detection box 23. Said light from the sample 10 is collected by the microscope objective 2 and is directed, via the mirror 25, the optical window 6 and the half mirror 18 onto the detector or camera system 4. The detector or camera system 4 such as a CCD camera, which in fact can be replaced by other type of detector such as a point to point detector. The vacuum chamber with housing 13 may in this example be vented via port 26 using commonly known pumping means.

The closed dashed line 23 encircles those parts of the inspection apparatus 20 of the invention that may all or some of them be mounted on the (replaceable) door 14' of the vacuum chamber 13. Clearly, the illumination and detection box 23 may be configured in other manners and may comprise any kind of microscope, including e.g. cathodoluminescence, laser confocal scanning and wide field microscope. Alternatively, the illumination and detection box 23 may as well be included fully inside, e.g. attached to a bottom part, said vacuum chamber 13.

In use, the optical microscope obtains an image from the sample 10 by illuminating the sample 10 using light form the light source 15, which is directed via the half mirror 18, the window 6, the mirror 25 and the microscope objective 2, onto the sample. Light from the sample 10 is collected by the microscope objective 2 and directed via the mirror 25, the window 6 and the half mirror 18, onto the camera 4. The camera 4 can register an image of the sample 10 as illuminated by the light source 15.

At a side of the sample 10 facing away from the microscope objective 2, the charged particle system 7 is arranged. In use, the charged particle system 7 directs a focused beam 9 of charged particles on the sample 10. Any primary or secondary backscattered charged particles and/or radiation is detected by the detector 8. By scanning said charged particle beam 9 over the surface of the sample 10 and registering the primary or secondary backscattered charged particles and/or radiation by said detector 8, an charged particle image of the surface of the sample 10 can be established.

In the following alternative methods are proposed of correlating the "charged particle image", i.e. image developed, i.e. generated by the processing unit and the charged particle part of the apparatus, to the "optical image", i.e. the image developed, i.e. generated by the processing unit and the optical part of the apparatus.

In addition to the registration and detection of an optical image and a charged particle image, the apparatus 20 is arranged for registration of an optical image, while said focused beam of charged particles impinges on a position on said sample 10. At said position on the sample 10, the focused beam 9 of charged particles induces a change in the optical image. Preferably said change is one of an increase or a decrease in brightness at the position of the charged particle beam.

The size of the focused beam 9 of charged particles on the sample 10 is much smaller than the optical resolution of the optical microscope system. The focused beam 9 generates a change in a spot in the optical image, which spot acts as a substantially perfect point source. The camera 4 registers an optical image of said point source. By analyzing an optical image of such a point source, the geometrical optical aberrations and distortions of the optical microscope system can be determined.

In addition the present invention enables to detect chromatic optical aberrations and distortions of the optical microscope system. For example, when the camera 4 is a color camera, or a camera arranged for establishing two or more optical images of substantially the same region of interest at two different wavelength ranges, these two or more optical images can be used to detect and characterize the chromatic optical aberrations and distortions of the optical microscopy system.

Figures 2A and 2B demonstrate two of various possible differences between detected images as discussed in the preceding. In these examples, the focused beam 9 of charged particles is scanned over the surface of the sample 10 in order to provide a matrix of points in the region of interest. The camera 4 obtains a first image (filled circles) and a second image (open circles) from the sample 10. Figure 2A represents a translation between two images, whereas Figure 2B represents an example of differing images in which each spot in the image has a different displacement due to aberrations and/or distortions.

For example, the optical microscope system and particularly the camera 4, is arranged for recording the first optical image (filled circles) of said two or more optical images by detecting light from a first wavelength range and for recording the second optical image (open circles) of said two or more optical images by detecting light from a second wavelength range, wherein the second wavelength range differs from the first wavelength range, preferably wherein the first and second wavelength ranges are spectrally separated. From these two images, the chromatic aberrations and/or distortions can be determined.

In an embodiment, the control unit is arranged to compute the aberrations and/or distortions in at least one of said images. In an embodiment, the control unit is provided with software to compute a transformed image of at least one of said images which transformed image is compensated for the aberrations and/or distortions.

### Improved Optical SEM inspection apparatus

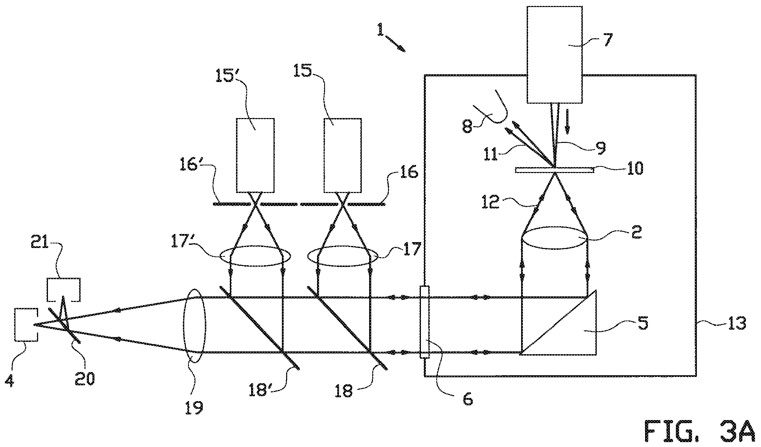

Various embodiments, as depicted in figures 3A-3D, of an integrated apparatus adapted for carrying out the method of the invention as described in the introductory part and in the annexed claims are conceived in the following description. An apparatus for carrying out the present invention may be configured with one or multiple light sources 15, 15' as well as with one or multiple detectors 4, 21. In principle virtually all combinations are possible in this respect.

With respect to the optical system, three principle situations are conceived:

In a first configuration as shown in figure 3A, multiple detectors 4, 21 are used for detecting different signals or images substantially simultaneous. These different images may be spectrally different images, or spatially different images. The images may however also be characterized by another difference.

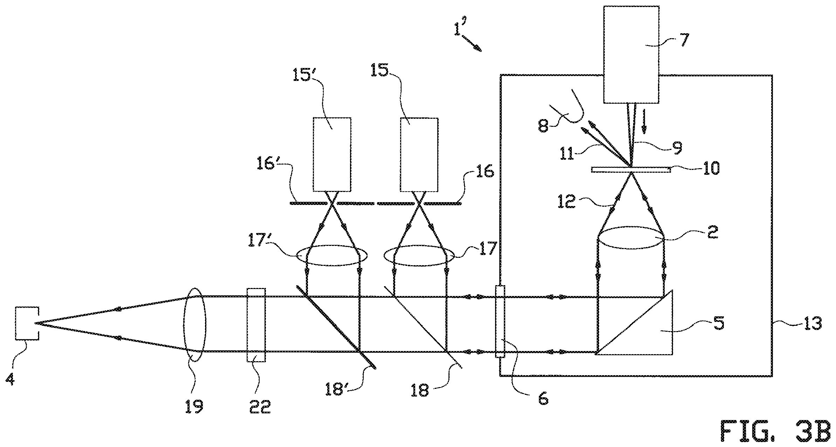

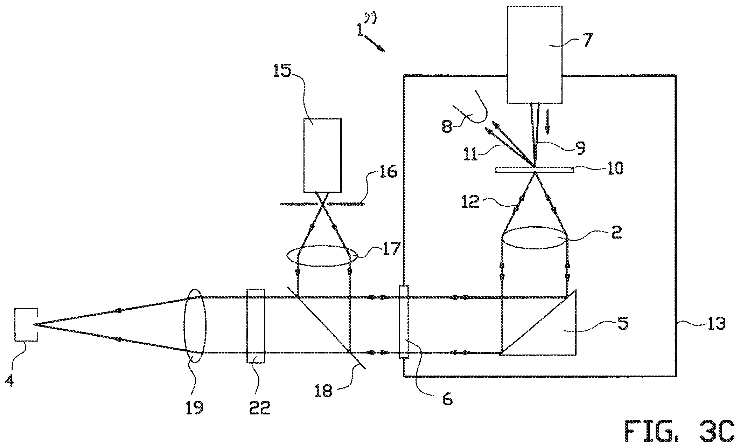

A second configuration as shown in figures 3B and 3C, comprises one detector 4 and a switching means 22 such as switching mechanism for switching between signals or images. For example the switching means 22 may comprise a set of optical band pass filters or an adjustable spectrometer in order to subsequently allow different wavelength ranges to pass said switching means 22 to be subsequently imaged on the detector 4.

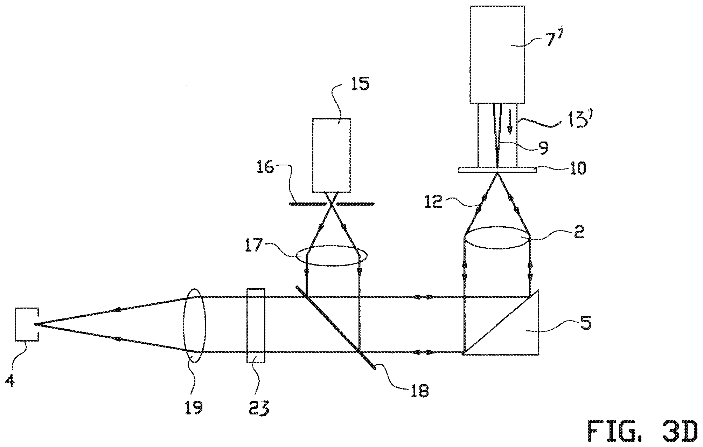

A third configuration as shown in figure 3D, relates to the characterization of optical components. Herein, one or multiple components 23' are added to the detection path and the difference is determined with the situation without the components.

With respect to the charged particle system 7, 8, the present invention in principle requires the presence of a charged particle system 7 generating a focused beam 9 of charged particles, the position of which beam 9 on the sample 10 may be changed in small steps. In practice such system will very often be a SEM and will therewith most often but not necessarily take place in vacuum. A detector 8 for secondary radiation and/or secondary charged particles as depicted in the examples as shown in figure 3A, 3B and 3C may hence be obviated in a system according to the invention.

In the examples as described above, figure 3A illustrates an integrated apparatus 1 in accordance with the invention provided with two detectors 4, 21 as well as with two illumination paths 16, 17, 18; 16', 17', 18', each with its own source 15; 15'.

Figure 3B illustrates an integrated system with a single detector 4 and two illumination path illumination paths 16, 17, 18; 16', 17', 18', each with its own source 15; 15'. This system 1' is provided with a manually or automatically changeable filter 22 in front of the single detector 4 for realizing different images with different filters in front of said detector 4. Said changeable filter 22 may comprise a set of optical band pass filters or an adjustable spectrometer in order to subsequently allow different wavelength ranges to pass and to be subsequently imaged on the detector 4.

In the example embodiment of figure 3C a simple system with a single illumination path 15, 16, 17, 18 and a single image detector 4 is schematically depicted. This system 1" is also provided with a manually or automatically changeable filter 22 in front of the single detector 4 for realizing different images with different filters in front of said detector 4.

Figure 3D finally depicts a system in accordance with either of the preceding three systems 1, 1', 1" could have been included and in which the charged particle system 7' is merely added to the integrated system for the purpose of providing a marker in the form of an charged particle spot. This system is designed atmospheric or vacuum, and wherein the charged particle beam 9 is for example surrounded by a cage 13' and may be displaced incrementally by small steps. This system relates to the characterization of optical components. Herein, one or multiple components 23' are added to the detection path and the difference is determined of the two images, one image is obtained without the additional component 23'and one image is obtained with the additional component 23'.

The above described examples use the charged particle beam 9 in order to provide a marker in the sample, which marker is used for determining aberrations and/or distortions of the optical microscope system or of an optical component in said system, in particular by analyzing and/or comparing two or more optical images which are recording at different optical wavelength ranges or colors.

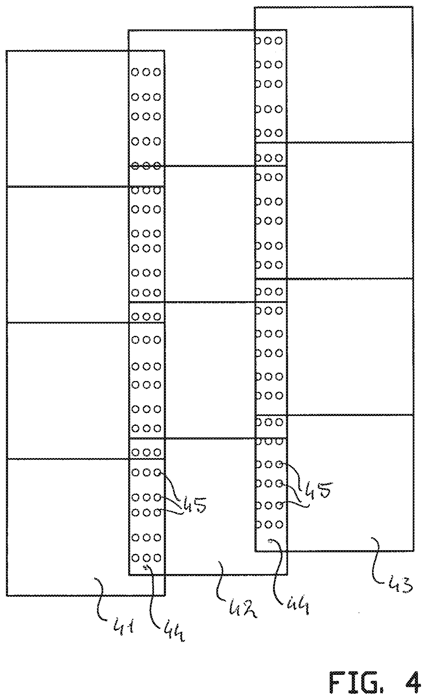

Figure 4 finally depicts the earlier described possibility with the system and method of the invention to overlay images of different areas 41, 42, 43, ... of the sample 10. Images of said different areas 41, 42, 43 can be recorded using different detectors. As indicated in figure 4, it is preferred that these areas 41, 42, 43 have an overlapping part 44. The circles 45 in the overlapping parts 44 indicate at which location the charged particle beam is arranged to impinge on the sample to establish suitable markers 45 which is detected in both the images of the different areas. These markers 45 are used to position and overlap the images of the different areas. Thereby creating the possibility of using multiple detectors, including but not limited to CCD's, as one detector. It is recognized in this respect that multiple detectors may "look" at different, but adjacent areas of a sample, and that the images need to be "stitched". In this manner a pattern can be written that overlaps different detectors while the overlap has been determined, and hence images are registered.

It is to be understood that the above description is included to illustrate the operation of the preferred embodiments and is not meant to limit the scope of the invention. From the above discussion, many variations will be apparent to one skilled in the art that would yet be encompassed by the scope of the present invention as defined in the appended independent claims. In summary, the invention relates to an apparatus and method for inspecting a sample, provided with an optical microscope to observe a region of interest on a sample and a charged particle system generating a focused charged particle beam to observe or modify the same or parts of the same region of interest, the apparatus provided with a control unit for electronically controlling said systems, adapted for recording two or more spectrally separated images of the region of interest on the sample, the control unit adapted for acquiring processing and representing the images as detected with said optical and said charged particle microscope systems, the unit further adapted for performing a registration procedure mutually correlating a region of interest in the optical images, wherein the apparatus is adapted for using a detection of a change in the optical images as caused therein by the charged particle beam for correlating said images.

Reference numbers as used in the present application denote:
1, 1', 1" inspection apparatus
2 light collecting device, infinity optical microscope objective
3 pinhole
4 detector or camera
5 mirror
6 optical window in housing 13
7, 7' charged particle system
8 detector for backscattered charged particles
9 primary charged particle beam
10 substrate and/or sample
11 secondary radiation and/or backscattering charged particles
12 luminescent or reflected light
13 housing of vacuum chamber
14 indication of parts that may be mounted to a removable door 14', c.q. wall
15, 15' light source
16, 16' pinhole
17, 17' lens
18, 18' half mirror
19 focusing lens
20 half mirror
21 second light detector
22 Changeable filter
23 Illumination and detection box
24 light optical path
25 Mirror
26 Venting port

## Claims

1. Apparatus for inspecting a sample, said apparatus comprising:
an optical microscope system to observe a region of interest on a sample,
a charged particle system which is arranged for generating a focused beam of charged particles and projecting said focused beam on a position on said sample within said region of interest, and
a control unit for controlling said apparatus, wherein said control unit is arranged for recording two or more optical images of said region of interest with said optical microscope system, at least when said focused beam of charged particles impinges on said sample, wherein the apparatus is arranged for correlating said two or more optical images by detecting a change in the two or more optical images as caused by said focused beam of charged particles.

2. The apparatus according to claim 1, wherein the control unit is arranged for determining aberrations and/or distortions of the optical microscope system by analyzing and/or comparing said two or more optical images.

3. The apparatus according to claim 1 or 2, wherein the control unit is arranged for detecting the position of said focused beam of charged particles on said sample in the two or more optical images, and using said detected position for correlating said two or more optical images preferably wherein the control unit is arranged for determining the position of said focused beam of charged particles with a precision that is better than the optical resolution of said optical microscope system, preferably by using a determination of a centroid or "center of mass" of the change as caused by said focused beam of charged particles.

4. The apparatus according to any one of claims 1 - 3, wherein said charged particle system is arranged for scanning said focused beam of charged particles over said region of interest to form a pattern comprising at least two, preferably a plurality of positions on the sample where said focused beam of charged particles impinges on said sample and/or wherein the optical microscope system is arranged for recording a first optical image of said two or more optical images by detecting light from a first wavelength range and recording a second optical image of said two or more optical images by detecting light from a second wavelength range, wherein the second wavelength range differs from the first wavelength range, preferably wherein the first and second wavelength ranges are spectrally separated.

5. The apparatus of any one of the preceding claims, wherein the correlation involves "clicking" a pointer, i.e. recording the position thereof in the optical images at the position of the focused beam of charged particles, preferably at two or more locations.

6. The apparatus according to any one of the claims 1 - 4, wherein the control unit is arranged for an automated, in particular software based, recognition and interpretation of the change in the optical images caused by the focused beam of charged particles.

7. The apparatus of any one of the claims 1 - 6, that is equipped with a sample or a part of a sample, or a substrate that holds the sample, or a calibration area, which is arranged for generating a change with a spectral bandwidth which at least matches the total bandwidth of the spectral detection channels of the optical microscope system and/or wherein said optical microscope system comprises one or more detection channels which are adapted to record different spectrally separated images successively by changing an optical component, such as a filter, in a manual or automated fashion, and wherein for each of the successively recorded images, the change induced by the focused beam of charged particles is induced at substantially the same positions on the sample, or at the same positions in the coordinate system of the charged particle microscope and/or wherein the apparatus is adapted to record one or more series consisting of charged particle beam images, optical images and induced changes in the optical images at multiple points in time, wherein the apparatus preferably is adapted to correct for detected effect of drift of any of the components of the apparatus on the registration between the optical images.

8. Method for registration of spectrally separated optical images in an apparatus for inspecting a sample, the apparatus equipped with an optical microscope system to observe a region of interest on a sample and a charged particle microscope having a column for producing a focused beam of charged particles to observe or modify the same or parts of the same region of interest on the sample, wherein the method comprises the steps of recording two or more spectrally separated images of the region of interest on the sample by the optical microscope system, detecting a change in each of the optical images caused by the charged particle beam, and correlating the mutual positions at which the change in said optical images is recorded in the image.

9. Method according to claim 8, wherein the method comprises correlating the positions of the change in the optical images to the position of the charged particle beam in the coordinate system of the charged particle microscope at a time the change was induced and/or wherein the method comprises determining the positions of the change in the optical images with a precision that is better than the optical resolution, using a determination of the center of gravity of the changes and/or wherein the method comprises performing a registration on one area on one sample and extrapolating the registration to the alignment on another area or on another sample and/or wherein the method comprises storing alignment parameters for different z-positions of a sample in the memory of a control unit and retrieving these parameters when the sample is positioned on a corresponding z-position.

10. Method according to any one of the claims 8 - 9, wherein the method comprises using a registration sample with a spectrally broad response to the charged particle beam, such as glass or ITO-coated glass and/or wherein the method comprises using a registration sample wherein the spectral response of the change induced in said registration sample by the charged particle beam matches the total spectral bandwidth of the optical images.

11. Method according to any of the claims 8 - 10, wherein the method comprises repetition of registration in time and correlating optical images thus sequentially acquired and/or wherein the method of registration comprises a recording of the charged particle image and/or the optical images in time during a registration procedure, and correcting for drift in the apparatus or components thereof during a registration procedure.

12. Method according to claim 8 for characterizing chromatic aberrations and/or distortions in one of a multi-color optical microscope system, and each or several of the separate components of the optical microscope system in an apparatus for inspecting a sample, said apparatus equipped with an optical microscope system.

13. Method according to the preceding claim, comprising the step of observing a region of interest on a sample and using a charged particle microscope integrated with said optical microscope system, wherein the method comprises correlating positions of the change in the optical images to the position of the charged particle beam in the coordinate system of the charged particle microscope at the time the change was induced, preferably wherein the method comprises inserting a component of an optical microscope such as an objective or a tube lens therein, to characterize chromatic aberrations and distortions in said component by comparing the magnitude and direction of aberrations and distortions measured in the situations with and without said component.

14. Apparatus according to claim 1, wherein said charged particle system is adapted for generating a focused beam of charged particles to observe or modify the same or parts of the same region of interest on the sample,
wherein said control unit is adapted for electronically controlling the apparatus,
wherein the control unit is adapted for acquiring processing and representing the images as detected with said optical microscope system and said charged particle microscope system, the unit further adapted for performing a registration procedure mutually correlating a region of interest in the optical images, wherein the apparatus is adapted for using a detection of a change in the optical images as caused therein by the charged particle beam for correlating said images.

15. Apparatus according to any one of the claims 1 - 7 and 14, wherein the unit is adapted for compensating aberrations and distortions between the optical images, and wherein said change in the optical images caused by the charged particle beam is used to calibrate the distortions and aberrations in the optical images.

## Patentansprüche

1. Vorrichtung zum Inspizieren einer Probe, wobei die Vorrichtung umfasst:
ein optisches Mikroskopsystem, um einen Bereich auf einer Probe, der von Interesse ist, zu betrachten,
ein geladener Teilchen System, welches darauf ausgelegt ist, einen fokussierten Strahl geladener Teilchen zu erzeugen und diesen fokussierten Strahl auf eine Stelle auf der Probe innerhalb des Bereichs von Interesse zu projizieren und
eine Steuerungseinheit zur Steuerung der Vorrichtung, wobei die Steuerungseinheit zum Aufzeichnen von zwei oder mehr optischen Bildern des Bereichs von Interesse mit dem optischen Mikroskopsystem ausgelegt ist, zumindest wenn der fokussierte Strahl der geladenen Teilchen auf die Probe trifft, wobei die Vorrichtung darauf ausgelegt ist, die zwei oder mehr optischen Bilder miteinander zu korrelieren durch Erkennen einer Veränderung in den zwei oder mehr optischen Bildern, wie sie durch den fokussierten Strahl geladener Teilchen hervorgerufen wird.

2. Die Vorrichtung gemäß Anspruch 1, wobei die Steuerungseinheit darauf ausgelegt ist, Aberrationen und/oder Verzerrungen des optischen Mikroskopsystems durch Analysieren und/oder Vergleichen der zwei oder mehr optischen Bilder zu ermitteln.

3. Die Vorrichtung gemäß Anspruch 1 oder 2, wobei die Steuerungseinheit auf das Erkennen der Position des fokussierten Strahls geladener Teilchen auf der Probe in den zwei oder mehr optischen Bildern und auf die Verwendung der erkannten Position zur Korrelation der zwei oder mehr optischen Bilder ausgelegt ist, wobei die Steuerungseinheit vorzugsweise auf die Ermittlung der Position des fokussierten Strahls geladener Teilchen mit einer Präzision, die besser als die optische Auflösung des optischen Mikroskopsystems ist, ausgelegt ist, vorzugsweise durch Verwendung einer Bestimmung eines Schwerpunkts oder "Massezentrums" der Veränderung, wie sie durch den fokussierten Strahl geladener Teilchen hervorgerufen wird.

4. Die Vorrichtung gemäß einem der Ansprüche 1 bis 3, wobei das Geladener Teilchen System auf das Abtasten des fokussierten Strahls geladener Teilchen über den Bereich des Interesses ausgelegt ist, um ein Muster umfassend mindestens zwei, vorzugsweise eine Vielzahl von Positionen auf der Probe zu bilden, wo der fokussierte Strahl geladener Teilchen auf die Probe auftrifft und/oder wobei das optische Mikroskopsystem auf die Aufzeichnung eines ersten optischen Bildes der zwei oder mehr optischen Bilder durch Detektion von Licht aus einem ersten Wellenlängenbereich und Aufzeichnung eines zweiten optischen Bildes der zwei oder mehr optischen Bilder durch Detektion von Licht aus einem zweiten Wellenlängenbereich ausgelegt ist, wobei sich der zweite Wellenlängenbereich von dem ersten Wellenlängenbereich unterscheidet, vorzugsweise wobei die ersten und zweiten Wellenlängenbereiche spektral getrennt sind.

5. Die Vorrichtung gemäß einem der vorhergehenden Ansprüche, wobei die Korrelation das "Anklicken" eines Signals, das heißt das Aufzeichnen der Position desselben in den optischen Bildern, an der Position des fokussierten Strahls geladener Teilchen umfasst, vorzugsweise an zwei oder mehr Positionen.

6. Die Vorrichtung gemäß einem der Ansprüche 1 bis 4, wobei die Steuerungseinheit auf eine automatische, insbesondere softwarebasierte, Erkennung und Interpretation der Veränderung in den optischen Bildern, die von dem fokussierten Strahl der geladenen Teilchen verursacht werden, ausgelegt ist.

7. Die Vorrichtung gemäß einem der Ansprüche 1 bis 6, die mit einer Probe oder einem Teil einer Probe oder einem Substrat, welches die Probe hält, oder einer Kalibrierungsfläche, die auf die Erzeugung einer Veränderung in einer spektralen Bandbreite, die zumindest auf die gesamte Bandbreite der spektralen Detektionskanäle des optischen Mikroskopsystems abgestimmt ist, ausgestattet ist und/oder wobei das optische Mikroskopsystem einen oder mehrere Detektionskanäle umfasst, die darauf ausgelegt sind, nacheinander unterschiedliche spektral getrennte Bilder durch Veränderung eines optischen Bestandteils, wie zum Beispiel ein Filter, in manueller oder automatisierter Weise aufzunehmen und wobei für jedes der nacheinander aufgezeichneten Bilder die Veränderung, die durch den fokussierten Strahl geladener Teilchen hervorgerufen wird, an den im Wesentlichen gleichen Stellen der Probe hervorgerufen wird oder an den gleichen Stellen in dem Koordinatensystem des Mikroskops mit geladenen Teilchen und/oder wobei die Vorrichtung darauf ausgelegt ist, eine oder mehrere Serien bestehend aus Bildern des Strahl geladener Teilchen, optischen Bildern und hervorgerufenen Veränderungen in den optischen Bildern zu mehreren Zeitpunkten aufzuzeichnen, wobei die Vorrichtung vorzugsweise darauf ausgelegt ist, die beobachtete Auswirkung der Drift eines beliebigen der Bestandteile der Vorrichtung bei Erfassung zwischen den optischen Bildern zu korrigieren.

8. Das Verfahren zur Erfassung spektral getrennter optischer Bilder in einer Vorrichtung zum Inspizieren einer Probe, wobei die Vorrichtung mit einem optischen Mikroskopsystem ausgestattet ist, um einen Bereich von Interesse auf einer Probe zu betrachten und mit einem Mikroskop mit geladenen Teilchen mit einer Säule zur Erzeugung eines fokussierten Strahls von geladenen Teilchen, um denselben oder Teile desselben Bereichs von Interesse auf der Probe zu beobachten oder zu modifizieren, wobei das Verfahren die Schritte des Aufzeichnens von zwei oder mehr spektral getrennten Bildern des Bereichs von Interesse auf der Probe durch das optische Mikroskopsystem, des Erfassens einer Veränderung in jedem der optischen Bilder, die durch den geladenen Teilchenstrahl hervorgerufen wird, und des Korrelierens der wechselseitigen Positionen, an welchen die Veränderung in den optischen Bildern aufgezeichnet wird, in dem Bild umfasst.

9. Das Verfahren gemäß Anspruch 8, wobei das Verfahren das Korrelieren der Positionen der Veränderung in den optischen Bildern mit der Position des Strahls geladener Teilchen in dem Koordinatensystem des Mikroskops mit geladenen Teilchen zu dem Zeitpunkt, an dem die Veränderung bewirkt wurde, umfasst und/oder wobei das Verfahren das Bestimmen der Positionen der Veränderung in den optischen Bildern mit einer Präzision, die besser als die optische Auflösung ist, unter Verwendung der Bestimmung eines Massenschwerpunkts der Veränderungen umfasst und/oder wobei das Verfahren das Durchführen einer Erfassung auf einer Fläche auf einer Probe und das Extrapolieren der Erfassung auf die Anpassung auf einer anderen Fläche oder auf einer anderen Probe umfasst und/oder wobei das Verfahren das Speichern von Anpassungsparametern für unterschiedliche z-Positionen einer Probe in dem Speicher einer Steuerungseinheit und Abrufen dieser Parameter, wenn die Probe in einer entsprechenden z-Position angeordnet wird, umfasst.

10. Das Verfahren gemäß einem der Ansprüche 8 bis 9, wobei das Verfahren die Verwendung einer Erfassungsprobe mit einer spektral breiten Antwort auf den Strahl geladener Teilchen umfasst, wie zum Beispiel Glas oder ITObeschichtetes Glas und/oder wobei das Verfahren die Verwendung einer Erfassungsprobe umfasst, wobei die spektrale Antwort auf die Veränderung, die in der Erfassungsprobe durch den Strahl geladener Teilchen hervorgerufen wird, auf die gesamte spektrale Bandbreite der optischen Bilder abgestimmt ist.

11. Das Verfahren gemäß einem der Ansprüche 8 bis 10, wobei das Verfahren eine zeitliche Wiederholung der Erfassung und das Korrelieren von auf diese Weise nacheinander erhaltenen optischen Bildern beinhaltet und/oder wobei das Verfahren der Erfassung das zeitliche Aufnehmen des Bildes der geladenen Teilchen und/oder der optischen Bilder während eines Erfassungsverfahrens und das Korrigieren um die Drift in der Vorrichtung oder Teilen derselben während eines Erfassungsverfahrens umfasst.

12. Das Verfahren gemäß Anspruch 8 zur Charakterisierung chromatischer Aberrationen und/oder Verzerrungen in einem von einem Mehrfarbenoptischen Mikroskopsystem und jedem oder einigen der einzelnen Bestandteile des optischen Mikroskopsystems in einer Vorrichtung zum Inspizieren einer Probe, wobei die Vorrichtung mit einem optischen Mikroskopsystem ausgestattet ist.

13. Das Verfahren gemäß einem der vorhergehenden Ansprüche, umfassend den Schritt des Betrachtens eines Bereichs auf einer Probe, der von Interesse ist, und des Verwendens eines Mikroskops mit geladenen Teilchen, das in dieses optische Mikroskopsystem integriert ist, wobei das Verfahren das Korrelieren von Positionen der Veränderung in den optischen Bildern mit der Position des Strahls geladener Teilchen in dem Koordinatensystem des Mikroskops mit geladenen Teilchen zu dem Zeitpunkt, an welchem die Veränderung bewirkt wurde, umfasst, wobei das Verfahren vorzugsweise das dortige Einführen eines Bestandteils eines optischen Mikroskops, wie zum Beispiel ein Objektiv oder eine Tubuslinse, umfasst, um die chromatischen Aberrationen und Verzerrungen in dem Bestandteil durch Vergleich des Ausmaßes und der Richtung der Aberrationen und Verzerrungen, die in den Situationen mit und ohne diesen Bestandteil gemessen werden, zu charakterisieren, umfasst.

14. Die Vorrichtung gemäß Anspruch 1, wobei das System geladener Teilchen auf die Erzeugung eines fokussierten Strahls geladener Teilchen ausgelegt ist, um denselben oder Teile desselben Bereichs von Interesse auf der Probe zu betrachten oder zu modifizieren,
wobei die Steuerungseinheit auf die elektronischen Steuerung der Vorrichtung ausgelegt ist,
wobei die Steuerungseinheit auf das Erfassen, Verarbeiten und Darstellen der Bilder, wie sie mit dem optischen Mikroskopsystem und dem Mikroskopsystem mit geladenen Teilchen aufgezeichnet werden, ausgelegt ist, wobei die Einheit weiterhin darauf ausgelegt ist, ein Erfassungsverfahren durchzuführen, welches einen Bereich von Interesse in den optischen Bildern wechselseitig korreliert, wobei die Vorrichtung darauf ausgelegt ist, die Erfassung einer Veränderung in den optischen Bildern, wie sie dort durch den Strahl geladener Teilchen verursacht wird, zur Korrelation der Bilder zu verwenden.

15. Die Vorrichtung gemäß einem der Ansprüche 1 bis 7 und 14, wobei die Einheit darauf ausgelegt ist, Aberrationen und Verzerrungen zwischen den optischen Bildern auszugleichen und wobei die Veränderung in den optischen Bildern, die durch den Strahl geladener Teilchen verursacht wird, verwendet wird, um die Verzerrungen und Aberrationen in den optischen Bildern zu kalibrieren.

## Revendications

1. Appareil destiné à inspecter un échantillon, ledit appareil comprenant :
un système de microscope optique permettant d'observer une région d'intérêt sur un échantillon,
un système à particules chargées qui est agencé pour produire un faisceau focalisé de particules chargées et projeter ledit faisceau focalisé sur une position dudit échantillon, au sein de ladite région d'intérêt, et
une unité de commande destinée à commander ledit appareil, ladite unité de commande étant agencée pour enregistrer deux ou plus de deux images optiques de ladite région d'intérêt avec ledit système de microscope optique, au moins lorsque ledit faisceau focalisé de particules chargées frappe ledit échantillon, l'appareil étant agencé pour corréler lesdites deux ou plus de deux images optiques en détectant un changement sur les deux ou plus de deux images optiques, tel que causé par ledit faisceau focalisé de particules chargées.

2. Appareil selon la revendication 1, dans lequel l'unité de commande est agencée pour déterminer des aberrations et/ou des distorsions du système de microscope optique en analysant et/ou en comparant lesdites deux ou plus de deux images optiques.

3. Appareil selon la revendication 1 ou 2, dans lequel l'unité de commande est agencée pour détecter la position dudit faisceau focalisé de particules chargées sur ledit échantillon sur les deux ou plus de deux images optiques, et pour utiliser ladite position détectée afin de corréler lesdites deux ou plus de deux images optiques, de préférence dans lequel l'unité de commande est agencée pour déterminer la position dudit faisceau focalisé de particules chargées avec une précision qui est meilleure que la résolution optique dudit système de microscope optique, de préférence en faisant appel à une détermination de centroïde ou « centre de masse » du changement tel que causé par ledit faisceau focalisé de particules chargées.

4. Appareil selon l'une quelconque des revendications 1 à 3, dans lequel ledit système à particules chargées est agencé pour balayer ledit faisceau focalisé de particules chargées sur ladite région d'intérêt afin de former un modèle comprenant au moins deux, de préférence une pluralité de, positions sur l'échantillon où ledit faisceau focalisé de particules chargées frappe ledit échantillon et/ou dans lequel le système de microscope optique est agencé pour enregistrer une première image optique desdites deux ou plus de deux images optiques en détectant la lumière comprise dans une première gamme de longueurs d'onde et pour enregistrer une seconde image optique desdites deux ou plus de deux images optiques en détectant la lumière comprise dans une seconde gamme de longueurs d'onde, la seconde gamme de longueurs d'onde différant de la première gamme de longueurs d'onde, de préférence les première et seconde gammes de longueurs d'onde étant spectralement séparées.

5. Appareil selon l'une quelconque des revendications précédentes, dans lequel la corrélation implique de « cliquer » sur un pointeur, c'est-à-dire d'en enregistrer la position sur les images optiques à la position du faisceau focalisé de particules chargées, de préférence à deux ou plus de deux emplacements.

6. Appareil selon l'une quelconque des revendications 1 à 4, dans lequel l'unité de commande est agencée pour une reconnaissance et une interprétation automatisées, en particulier logicielles, du changement sur les images optiques, causé par le faisceau focalisé de particules chargées.

7. Appareil selon l'une quelconque des revendications 1 à 6, qui est équipé d'un échantillon ou d'une partie d'échantillon, ou d'un substrat qui supporte l'échantillon, ou d'une zone d'étalonnage, qui est conçu(e) pour produire un changement dans une largeur de bande spectrale qui concorde au moins avec la largeur de bande totale des canaux de détection spectrale du système de microscope optique et/ou dans lequel ledit système de microscope optique comprend un ou plusieurs canaux de détection qui sont conçus pour enregistrer successivement différentes images spectralement séparées, en changeant un composant optique, tel qu'un filtre, de façon manuelle ou automatisée, et dans lequel, pour chacune des images successivement enregistrées, le changement induit par le faisceau focalisé de particules chargées est induit sensiblement aux mêmes positions sur l'échantillon, ou aux mêmes positions dans le système de coordonnées du microscope à particules chargées et/ou l'appareil étant conçu pour enregistrer une ou plusieurs séries composées d'images de faisceau de particules chargées, d'images optiques et de changements induits sur les images optiques à de multiples instants, l'appareil étant conçu de préférence pour corriger un effet détecté de dérive de l'un quelconque des composants de l'appareil sur le repérage entre les images optiques.

8. Procédé de repérage d'images optiques spectralement séparées dans un appareil destiné à inspecter un échantillon, l'appareil étant équipé d'un système de microscope optique pour observer une région d'intérêt sur un échantillon et d'un microscope à particules chargées comportant une colonne destinée à produire un faisceau focalisé de particules chargées pour observer ou modifier la même région d'intérêt ou des parties de celle-ci sur l'échantillon, le procédé comprenant les étapes consistant à enregistrer deux ou plus de deux images spectralement séparées de la région d'intérêt sur l'échantillon au moyen du système de microscope optique, à détecter un changement sur chacune des images optiques, causé par le faisceau de particules chargées, et à corréler les positions mutuelles auxquelles le changement sur lesdites images optiques est enregistré sur l'image.

9. Procédé selon la revendication 8, le procédé comprenant la corrélation des positions du changement sur les images optiques à la position du faisceau de particules chargées dans le système de coordonnées du microscope à particules chargées à un moment où le changement a été induit et/ou le procédé comprenant la détermination des positions du changement sur les images optiques avec une précision qui est meilleure que la résolution optique, à l'aide d'une détermination du centre de gravité des changements et/ou le procédé comprenant la réalisation d'un repérage sur une zone d'un échantillon et l'extrapolation du repérage à l'alignement sur une autre zone ou un autre échantillon et/ou le procédé comprenant le stockage de paramètres d'alignement de différentes positions z d'un échantillon dans la mémoire d'une unité de commande et la récupération de ces paramètres lorsque l'échantillon est positionné sur une position z correspondante.

10. Procédé selon l'une quelconque des revendications 8 et 9, le procédé comprenant l'utilisation d'un échantillon de repérage ayant une réponse spectralement large au faisceau de particules chargées, tel que du verre ou du verre revêtu d'oxyde d'étain et d'indium et/ou le procédé comprenant l'utilisation d'un échantillon de repérage dans lequel la réponse spectrale du changement induit dans ledit échantillon de repérage par le faisceau de particules chargées concorde avec la largeur de bande spectrale totale des images optiques.

11. Procédé selon l'une quelconque des revendications 8 à 10, le procédé comprenant la répétition du repérage dans le temps et la corrélation d'images optiques ainsi acquises de manière séquentielle et/ou le procédé de repérage comprenant un enregistrement de l'image à particules chargées et/ou des images optiques dans le temps au cours d'une procédure de repérage, et la correction de dérive de l'appareil ou de composants de celui-ci au cours d'une procédure de repérage.

12. Procédé selon la revendication 8 pour caractériser des aberrations et/ou distorsions chromatiques dans l'un parmi un système de microscope optique polychromatique, et chacun ou plusieurs des composants séparés du système de microscope optique dans un appareil destiné à inspecter un échantillon, ledit appareil étant équipé d'un système de microscope optique.

13. Procédé selon la revendication précédente, comprenant l'étape consistant à observer une région d'intérêt sur un échantillon et à utiliser un microscope à particules chargées intégré audit système de microscope optique, le procédé comprenant la corrélation de positions du changement sur les images optiques à la position du faisceau de particules chargées dans le système de coordonnées du microscope à particules chargées au moment où le changement a été induit, de préférence le procédé comprenant l'introduction d'un composant de microscope optique, tel qu'un objectif ou une lentille de tube dans celui-ci, pour caractériser des aberrations chromatiques et des distorsions dans ledit composant, en comparant la grandeur et la direction d'aberrations et de distorsions, mesurées dans des situations avec et sans ledit composant.

14. Appareil selon la revendication 1, dans lequel ledit système à particules chargées est conçu pour produire un faisceau focalisé de particules chargées afin d'observer ou de modifier la même région ou des parties de celle-ci sur l'échantillon,
dans lequel ladite unité de commande est conçue pour commander l'appareil électroniquement,
dans lequel l'unité de commande est conçue pour acquérir, traiter et représenter les images telles que détectées avec ledit système de microscope optique et ledit système de microscope à particules chargées, l'unité étant conçue en outre pour réaliser une procédure de repérage corrélant mutuellement une région d'intérêt sur les images optiques, l'appareil étant conçu pour utiliser une détection de changement sur les images optiques, tel que causé sur celles-ci par le faisceau de particules chargées pour corréler lesdites images.

15. Appareil selon l'une quelconque des revendications 1 à 7 et 14, dans lequel l'unité est conçue pour compenser des aberrations et des distorsions entre les images optiques, et dans lequel ledit changement sur les images optiques, causé par le faisceau de particules chargées, est utilisé pour étalonner les distorsions et aberrations sur les images optiques.
